# EUROPEAN PATENT APPLICATION

(11) **EP 4 656 441 A1**
(43) Date of publication of application: **03.12.2025**
(21) Application number: 25155111.5
(22) Date of filing: 30.01.2025
(51) Int. Cl.: B60L 53/10, B60L 53/14, B60L 53/302, F24H 1/20, F25B 41/24, F25B 49/00, H05K 7/20, B60H 1/00, B60H 1/14, B60L 53/31, F25B 40/02, H02J 7/00

(54) **SYSTEM FOR COOLING AND RECOVERING WASTE HEAT OF THE AD/DC CONVERTER OF THE CHARGING STATION DURING CHARGING OF THE VEHICLE TRACTION BATTERY**

(30) Priority: 31.05.2024 PL 44873024
(71) Applicant: Ekoenergetyka - Polska Spolka Akcyjna, 66-002 Zielona Gora (PL)
(72) Inventor: JARNUT, Marcin, 66-004 Zielona Gora (PL); KANIEWSKI, Jacek, 66-004 Zielona Góra (PL); BUCIAKOWSKI, Mariusz, 68-200 ary (PL)
(74) Representative: Grzelak, Anna

(57) **Abstract**

The object of the invention is a charger cooling and waste heat recovering system, as well as a method for cooling and recovering waste heat from a liquid cooled charger for heating technical water.

A liquid cooled charger cooling and waste heat recovery system with a heat exchanger, control unit, cooling system controller, wherein the liquid that cools the charger is cooled directly in a liquid-liquid heat exchanger (**TWHC**) installed in a technical water tank (**TWT**); wherein between the heat exchanger and the cooled and heated liquid connectors there are a cooled liquid collector (**CLC**) with a cooled liquid temperature sensor (**TS1**) and a heated liquid collector (**HLC**) with a heated liquid temperature sensor (**TS2**), as well as a circulating pump (**HSCP**).

The method for cooling and recovering the waste heat from the charger by means of the cooling and heat recovery system wherein the flow of liquid in the cooling system starts when charging process starts and is deactivated when the temperature in the heated liquid collector (**HLC**) falls below the set threshold.

## Description

### FIELD OF TECHNOLOGY

The invention relates to a cooling and waste heat recovering system from a charger and a method for cooling and recovering waste heat from a liquid cooled charger for heating technical water.

### STATE OF THE ART

Rechargers that convert AC energy to DC are widely used in the economy.

The specification of the U.S. Patent no. US 10688873 B2 provides a recharging system for electric vehicles, having: a charger to which the traction battery of an electric vehicle can be connected by means of a charging cable; the power electronics systems, charger may be connected, by means of the power electronics systems, to an electrical current and voltage supply network providing a specified power of the electrical network; an electrical energy storage which is connected between the electrical current and voltage supply network and the charger in such a way that the said electrical energy storage is charged with the power of the electricity network and is discharged with the charging power of the charger; a recooling device, charger, energy electronics system and electrical energy storage are connected to the recooling device that provides a specified recooling heat output; a thermal energy storage device shall be connected to the recooling device, to the charger, to the energy electronics system and to the electrical energy storage in such a way that the said thermal energy storage or cooling medium of the said storage device is heated by the power losses of the energy electronics systems, charger and electrical energy storage and may be cooled by the thermal power of the recooling device.
the specification of the U.S. Patent Application no. US 2016129797 A1**,** there is known a method and system for electric vehicles, such as battery electric vehicles and hybrid plug-in electric vehicles, comprising pre-cooling traction battery of the vehicle after indication that the vehicle is directed to the charger. Pre-cooling is performed by the on-board cooling system of the battery. Pre-cooling depends on the distance between vehicle and charger.

From the specification of the subsequent U.S. Patent no. US 10457153 B2 there is known a charger system, in particular for electric vehicles; wherein the charger system has at least one housing. The charger system also has many main components. The housing and the main components are standardized in such a way that the main components can be arranged in the housing in a modular way. A related method of construction of chargers is also described.

During the operation of chargers, power losses occur as a result of converting AC energy to DC energy (AC/DC) and as a result of electric flow. These losses mainly occur in power electronics converters, which make up the so-called converter power blocks installed in the charger. These losses amount to about 5% of the current capacity of the charger and are entirely converted into heat. In high-speed chargers with capacities of hundreds of kilowatts (kW) and in the case of charging HUB-s with powers of the order of single megawatts (MW), the amount of heat released becomes significant and is responsible for heating the charger. Due to the boundary performance of the charger and the life of its components, the heat resulting from power losses should be efficiently discharged from the charger. Forced-air-flow (air cooling) systems, in which converters are equipped with compressor fans that force the air flow, are a known and most commonly used solution. A major drawback of such solutions is the high dependency of cooling efficiency on the temperature of the cooling air compressed by the converter fans (dependency on ambient temperature). Moreover, ensuring an adequate volume flow of cooling air requires the use of a large number of high-speed compressor fans. As a result, a high sound pressure level, i.e. noise, is generated during the charging and operation of the compressor fans that force the air flow. Moreover, the outlet air temperature often reaches values exceeding 65 degrees Celsius, which may cause the tactile temperature limits to be exceeded on the surface of the charger housing and present a risk of burns.

More efficient solutions are systems using liquid cooling. In these solutions, the elements of the converters generating the highest waste heat are placed on the so-called cooling plates. The liquid passing through the cooling plate receives the heat energy generated by losses from the AC/DC converter, which is then dispersed in the liquid-air heat exchanger. This solution, due to more freedom steps in temperature control, e.g. air flow, liquid flow through the exchanger, another type of fan that forces air flow through the exchanger (larger diameter, low rotational speed, often adjustable) and their low number generate low noise, which is more environment-friendly. However, these solutions still do not eliminate the influence of ambient temperature on efficient cooling and on the temperature parameters of the outlet air.

A common drawback of air and liquid cooling systems is that waste heat generated during power losses in the system is irrecoverably lost through its dispersal into the environment. These solutions do not improve the energy balance and do not improve the efficiency ratio of chargers in any way. Moreover, liquid cooling systems are equipped with circulating pumps that increase the consumption of energy for the station's own needs.

From literature and existing industrial solutions, there are known electric vehicle charger systems with waste heat recovery for garage, office and social space heating. However, a common drawback of systems in which waste heat is used for space heating is their seasonal use. When the ambient temperature is so high that there is no need to heat the premises, the waste heat is dispersed in the liquid-air exchangers into the ambient, thus retaining all the characteristics and defects of the classical liquid cooling systems. Moreover, there is a restriction on localisation. Charging stations must be installed in the immediate vicinity of buildings, offices, social housing, etc., the existing heating systems of which can be combined with the liquid cooling systems of the charger.

Existing solutions do not allow waste heat to be managed for purposes other than space heating, improving the efficiency rate of chargers regardless of ambient temperature and atmospheric conditions.

### DISCLOSURE OF THE INVENTION

The technical problem solved by the invention is the recovery of waste heat, which is obtained by the liquid cooling of chargers for electric vehicles.

Moreover, a technical problem is how waste heat, which is obtained by the liquid cooling of chargers for electric vehicles, is recovered.

In view of the prior art described, the purpose of the present invention is to overcome the said disadvantages and to provide a device which, through the use of heat exchangers, enables heat to be recovered from the liquid that cools the charger for electric vehicles.

A liquid cooled charger cooling and waste heat recovery system having in its structure a heat exchanger, a control unit, and a cooling system controller is characterised by the fact that the liquid cooling the charger is cooled directly in the liquid-liquid exchanger installed in the technical water tank; wherein between the heat exchanger and the cool-hot liquid connector there are installed a cooled liquid collector with the cool liquid temperature sensor and a heated liquid collector with the hot liquid temperature sensor, as well as a circulating pump.
Preferably, it has a peak liquid-air heat exchanger, the liquid source of which is connected by means of a controlled three-way hot liquid valve.
Preferably, it has a low closed liquid-liquid source consisting of the heat exchanger of the technical water storage tank and it has a high closed source consisting of the high heat source in the form of a cooling plate of the converter; wherein the sources are connected by an intermediate heat exchanger; wherein each source has a separate circulating pump.

The method for cooling and recovering the waste heat from the charger by means of a cooling and heat recovery system as specified above, in which the circulating pump is activated at the same time as the charging process starts and liquid in the cooling system is forced to flow through the cooled liquid collector, the cooling plate of the converter, the heated liquid collector and the heat exchanger in the technical water tank, while simultaneously in the cooling system controller the temperatures measured, respectively, in the cooled liquid collector and the heated liquid collector are read, based on the temperature difference the flow of liquid in the cooling system is controlled by a pump; wherein, when the temperature exceeds the threshold, the TWV-ON signal of the three-way controlled valve is activated in system with the peak heat exchanger system and the flow of liquid through the heat exchanger is forced; wherein the signal is deactivated when the temperature is below the threshold, switching the three-way controlled valve to the starting position and the flow of the cooling liquid through the heat exchanger is restored in the technical water tank; it is characteristic that the flow of liquid in the cooling system is activated when charging process starts and is deactivated when the temperature in the heated liquid collector falls below the set threshold.
Preferably, after exceeding the temperature threshold in the cooled liquid collector, the three-way valve controlled by the signal is activated and the flow of cooling liquids through the peak liquid-air heat exchanger.
Preferably, the flow of liquid in the high and low source system is activated when the charging process starts, respectively, with the HSCP-ON and LSCP-ON signals; wherein after exceeding the temperature threshold in the cooled liquid collector, the three-way signal-controlled valve is activated and the flow of cooling liquids through the peak liquid-air heat exchanger; wherein when the temperature at the heat exchanger outlet in the technical water tank falls below the threshold, the three-way valve is deactivated, and the cooling liquid circulates again through the intermediate heat exchanger, while the flow of liquid in the low and high source system is deactivated when the temperature in the heated liquid collector falls below the set threshold.

The advantage of the solution used is the charger liquid cooling system with waste heat recovery according to the invention, where the function of the low heat source is played by the technical water tank, which is heated with the waste heat of the charger for electric vehicles. In the system according to the invention, waste heat is accumulated in a hot technical water tank and the technical water heated with the heat waste is used. With sufficient technical water demand and sufficient capacity of the hot technical water storage tank, it allows efficient heat reception from the charger. Moreover, in the system according to the invention, under extremely unfavourable operating conditions, when the charger operates at maximum capacity and there is no need for hot technical water, a peak heat exchanger may be used which allows efficient cooling of the charger ensuring its full functionality.

### BRIEF DESCRIPTION OF THE DRAWING FIGURES

For a better understanding of the invention, it is illustrated in embodiments and in the attached figures, in which:
**Fig. 1** shows a view of the liquid cooled charger cooling and waste heat recovery system;
**Fig. 2** present a view of the liquid cooled charger cooling and waste heat recovery system with the peak exchanger;
**Fig. 3** shows a view of the liquid cooled charger cooling and waste heat recovery system with a peak exchanger and the intermediate heat exchanger;
**Fig. 4** shows exemplary time runs in the liquid cooled charger cooling and waste heat recovery system;
**Fig. 5** shows exemplary time runs in the liquid cooled charger cooling and waste heat recovery system with the peak and intermediate heat exchanger.

The liquid cooled charger cooling and waste heat recovery system on the attached figures is only shown as an illustration, whereas the final shape with specific parameters depends on the characteristics of the device.

### METHODS OF CARRYING OUT THE INVENTION

The following examples illustrate the invention without limiting it in any way.

### Example 1. Liquid cooled charger waste cooling and heat recovery system

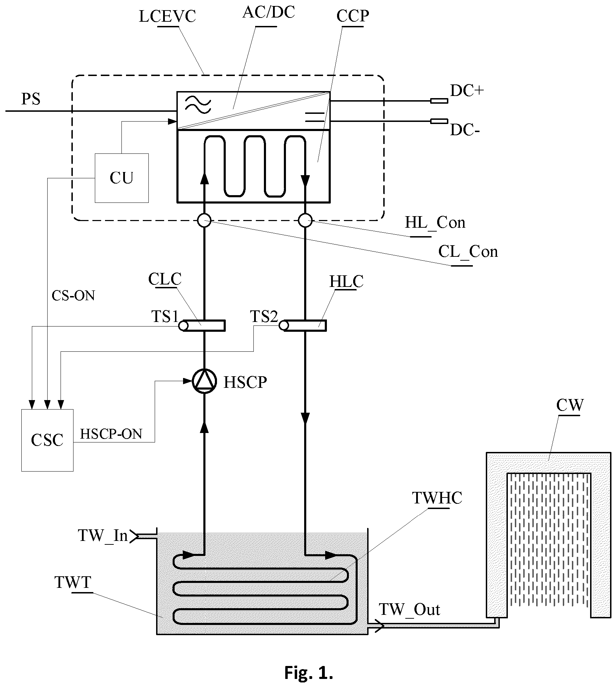

The charger liquid cooling system with waste heat recovery according to the invention includes in its structure a high heat source in the form of a converter cooling plate **CCP,** a low heat source in the form of a liquid-liquid exchanger **TWHC** installed in a technical water tank **TWT** between the peak and low heat sources there are a heated liquid collector **HLC** with a temperature sensor **TS2** and a cooled liquid collector **CLC** with a temperature sensor **TS1,** as well as a circulating pump **HSCP,** as shown in **FIG. 1****.** The output of the converter cooling plate **CCP,** using tubes or flexible hoses, through the heated liquid connector **HL_Con,** is connected to the input of the heated liquid collector **HLC.** The outlet of the heated liquid collector is directly connected to the inlet of the technical water heat exchanger **TWHC.** The outlet of the technical water heat exchanger **TWHC** is connected to the inlet of the circulating pump **HSCP,** and the outlet of the circulating pump **HSCP** is connected to the cooled liquid collector **HSCP,** the outlet of which is connected via the cooled liquid connector **CL_Con** to the inlet of the cooling plate **CCP** of the **AC/DC** converter.

### Example 2. Liquid cooled charger waste cooling and heat recovery system

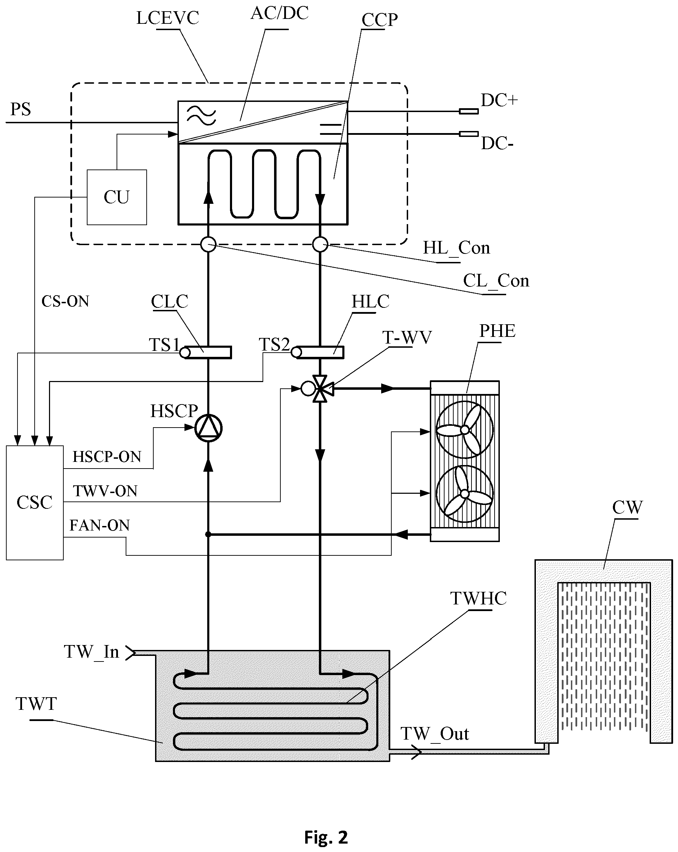

**FIG. 2** shows a cooling and waste heat recovering system which is identical to that disclosed in **Example 1,** except that it has a peak heat exchanger **PHE.**

### Example 3. Liquid cooled charger waste cooling and heat recovery system

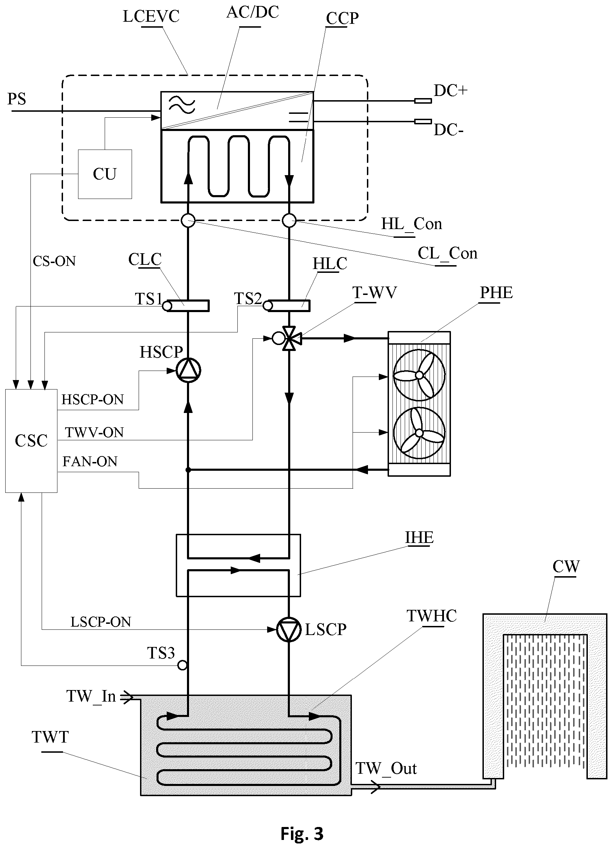

**FIG. 3** shows a cooling and waste heat recovering system that is identical to that disclosed in **Example 1** and **Example 2,** except that it has a peak heat exchanger **PHE** and an intermediate heat exchanger **IHE.**

The liquid cooled charger waste cooling and heat recovery system according to the invention additionally includes in its structure a peak heat exchanger **PHE,** the input of which is connected to the output of the controlled three-way valve **T-WV,** the input of which is connected to the output of the heated liquid collector **HLC,** and the second output is directly connected to the input of the technical water heat exchanger **TWHC** (low source) or to the input of the high source of the intermediate heat exchanger **IHE.** However, the output of the peak heat exchanger **PHE** is connected directly between the inlets of the high source circulating pump **HSCP** and the outlet of the low source heat exchanger **TWHC** or directly between the inlets of the high source circulating pump **HSCP** and the outlet of the high source of the intermediate heat exchanger **IHE.** The output of the low source of the intermediate source heat exchanger **IHE** is connected to the low source circulating pump **LSCP,** the output of which is connected to the inlet of the technical water heat exchanger **TWHC,** the output of which is connected to the inlet of the low source of the intermediate heat exchanger **IHE.** Moreover, there is a temperature sensor **TS3** at the outlet of the low source.

### Example 4. Method for cooling and recovering waste heat

The method is implemented by means of a device as described in **Example 3.**

Once the charging process starts, the high source circulating pump **HSCP** and the low source circulating pump **LSCP** are activated with, respectively, **HSCP-ON** signal and **LSCP-ON** signal. After completion of the charging process, circulating pumps remain active until the temperature **TS2** in the heated liquid collector **HLC** falls below the threshold. In critical case, where no heat is received in the low source heat exchanger **TWHC** and the temperature **TS1** in the cooled liquid collector **CLC** increases above the threshold **Tmax,** the **TWV-ON** signal is activated the three-way valve **T-WV,** the liquid is redirected to the peak heat exchanger **PHE,** the fans of which activate the **FAN-ON** signal. The low source in the form of the technical water heat exchanger returns to cooling and heat receipt occurs after the temperature in the cooled liquid collector has fallen below the threshold **Tmin** or if in the source of the intermediate exchanger **IHE** below the temperature **TS3** there is a factor at the outlet of the exchanger **TWHC.**

### Example 5. Method for cooling and recovering waste heat

The method is implemented by means of a device as described in **Example 1.**

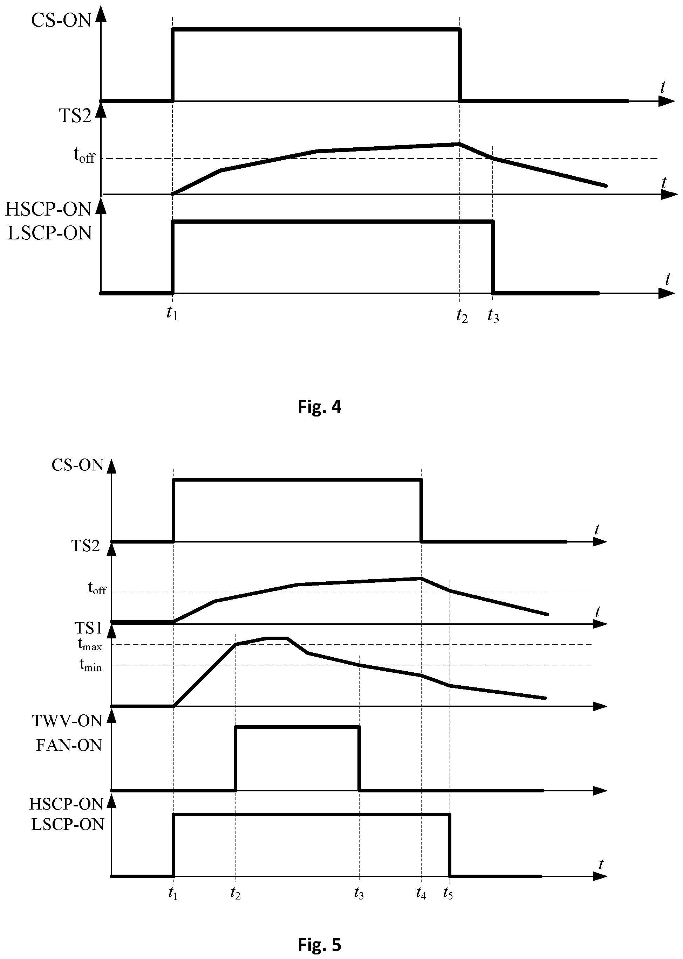

When the charging process starts, the **HSCP-ON** signal is activated the circulating pump **HSCP** that forces the flow of liquid in the cooling and heat recovery system. The pump is deactivated and the flow is stopped after completion of the charging process and after the temperature TS2 measured in the heated liquid collector HLC has decreased below the threshold **Toff** in **Fig. 4****.**

### LIST OF INDICATIONS:

**AC/DC** - AC to DC Converter (*Alternating Current* / *Direct Current*);
**CCP** - Converter Cooling Plate (*Converter Cooling Plate*);
**CLC** - Cooled Liquid Collector (*Cooled Liquid Collector*);
**CL_Con** - Cooled Liquid Connector (*Cooled liquid connector*);
**CS-ON** - Cooling System ON (*Cooling System ON*);
**CSC** - Cooling System Controller (*Cooling System Controller*);
**CU** - Control Unit (*Control Unit);*
**CW** - Car Wash (*Car Wash*);
**DC+** - DC Positive Pole (*Direct Current Positive Pole*);
**DC-** - DC Negative Pole (*Direct Current Negative Pole*);
**FAN-ON** - Fans ON (*Fans ON*);
**HLC** - Heated Liquid Collector (*Heated Liquid Collector*);
**HL_Con** - Heated Liquid Connector (*Heated Liquid Connector*);
**HSCP** - High Source Circulating Pump (*High Source Circulating Pump*);
**HSCP-ON** - High Source Circulating Pump ON *(High Source Circulating Pump ON)*;
**IHE** - Intermediate Heat Exchanger (*Intermediate Heat Exchanger*);
**LCEVC** - Liquid Cooled Electrical Vehicle Charger *(Liquid Cooled Electrical Vehicle Charger);*
**LSCP** - Low Source Circulating Pump (*Low Source Circulating Pump*);
**LSCP-ON** - Low Source Circulating Pump ON (*Low Source Circulating Pump ON*);
**PHE** - Peak Heat Exchanger (*Peak Heat Exchanger*);
**PS** - Power Supply (*Power Supply*);
**TS1** - Cooled Liquid Temperature Sensor (*Temperature Sensor 1*);
**TS2** - Heated Liquid Temperature Sensor (*Temperature Sensor 2*);
**TS3** - Low Source Liquid Temperature Sensor (*Temperature Sensor 3*);
**TWHC** - Technical Water Heat Exchanger (*Technical Water Heat Exchanger*);
**TW_in** - Technical Water Inlet (*Technical Water Inlet*);
**TW_out** - Technical Water Outlet (*Technical Water Outlet*);
**TWT** - Technical Water Tank (*Technical Water Tank*);
**T-WV** - Heated Liquid Three-Way Valve (*Three-Way Valve*);
**TWV-ON** - Three-Way Valve ON (*Three-Way Valve ON*);

## Claims

1. A liquid cooled charger cooling and waste heat recovery system including in its structure a heat exchanger, a control unit, a cooling system controller, **characterised in that** the liquid cooling the charger is cooled directly in the liquid-liquid exchanger **(TWHC)** installed in the technical water tank **(TWT);** wherein between the heat exchanger and the cooled liquid connector there are the cooled liquid collector **(CLC)** with the cooled liquid temperature sensor **(TS1)** and the heated liquid collector **(HLC)** with the heated liquid temperature sensor **(TS2),** as well as the circulating pump **(HSCP).**

2. The liquid cooled charger cooling and waste heat recovering system according to claim 1, **characterised in that** it has the liquid-air peak heat exchanger **(PHE),** the liquid source of which is connected by means of the heated liquid three-way valve **(T-WV).**

3. The liquid cooled charger cooling and waste heat recovering system according to claim 1-2, **characterised in that** it has a closed low liquid-liquid source consisting of the heat exchanger of the technical water storage tank and it has a closed high source consisting of the higher heat source in the form of the converter cooling plate **(CCP);** wherein the sources are connected to the intermediate heat exchanger **(IHE);** wherein each source has a separate circulating pump **(LSCP, HSCP).**

4. A method for cooling and recovering the waste heat from the charger by means of the cooling and heat recovery system as specified in claims 1-3, in which the circulating pump **(HSCP)** is activated simultaneously from the start of the charging process and the flow of liquid in the cooling system is forced through the cooled liquid collector **(CLC),** the converter cooling plate **(CCP),** the heated liquid collector **(HLC)** and the heat exchanger **(TWHC)** in the technical water tank **(TWT);** at the same time the temperatures **(TS1)** and **(TS2)** measured in, respectively, the cooled liquid collector **(CLC)** and the heated liquid collector **(HLC),** are read; based on the **(TS1)** and **(TS2)** temperature difference, the flow of liquid in the cooling system is controlled by means of the pump **(HCSP;** wherein when the temperature **(TS1)** is exceeded above the threshold, the **TWV-ON** signal of the three-way controlled valve **(T-WH)** is activated in the system with the peak heat exchanger **(PHE)** and the flow of liquid through the exchanger **(PHE)** is forced; wherein the signal is deactivated when the temperature **(TS1)** falls below the threshold, switching the three-way controlled valve **(T-WH)** to the starting position, and the flow of cooling liquid through the heat exchanger **(TWHC)** in the technical water tank **(TWT)** is restored, **characterised in that** the flow of liquid in the cooling system is activated when the charging process starts and is deactivated when the temperature in the heated liquid collector **(HLC)** falls below the set threshold.

5. The method for cooling and recovering the waste heat from the charger according to claim 4, **characterised in that** after exceeding the temperature threshold in the cooled liquid collector **(CLC),** the three-way valve **(T-WV)** controlled by the signal **(T_WV_ON)** is activated, and the cooling liquid flows through the liquid-air peak heat exchanger **(PHE).**

6. The method for cooling and recovering the waste heat from the charger according to claims 4-5, **characterised in that** the flow of liquid in the high and low source system is activated, when the charging process starts, with the corresponding **HSCP-ON** and **LSCP-ON** signals; wherein after exceeding the temperature threshold in the cooled liquid collector **(CLC),** the three-way controlled valve **(T-WV)** is activated with the signal **(T_WV_ON),** and the cooling liquid flows through the liquid-air peak heat exchanger **(PHE);** wherein when the temperature **(TS3)** at the outlet of the technical water heat exchanger falls below the threshold, the three-way valve **(T-WV)** is deactivated and the cooling liquid circulates again through the intermediate heat exchanger **(IHE),** while the flow of liquid in the low and high source system is deactivated when the temperature in the heated liquid collector **(HLC)** falls below the set threshold.
